# DEMANDE DE BREVET EUROPEEN

(11) **EP 1 315 202 A1**
(43) Date de publication de la demande: **28.05.2003**
(21) Numéro de dépôt: 02354181.6
(22) Date de dépôt: 21.11.2002
(51) Int. Cl.: H01L 21/329, H01L 29/872

(54) **Procédé de réalisation d'une diode schottky sur substrat de carbure de silicium**

(30) Priorité: 21.11.2001 FR 0115026
(71) Demandeur: STMicroelectronics S.A., 92120 Montrouge (FR)
(72) Inventeur: Lanois, Frédéric, 37100 Tours (FR)
(74) Mandataire: de Beaumont, Michel

(57) **Abrégé**

L'invention concerne un procédé de fabrication d'une diode Schottky verticale à anneau de garde sur une couche de carbure de silicium faiblement dopée de type N, comprenant les étapes consistant à former une couche épitaxiée de type P sur la couche de type N ; implanter des dopants de type N dans des zones de la couche épitaxiée de type P pour neutraliser dans ces zones, sur toute l'épaisseur de la couche épitaxiée, les dopants de type P de façon à former des régions de type N, de concentration de dopants inférieure à celle de la couche épitaxiée, et délimiter un anneau de garde de type P ; former sur la périphérie externe du composant une couche isolante recouvrant partiellement l'anneau de garde ; et former un contact Schottky avec la région de type N interne à l'anneau de garde.

## Description

La présente invention concerne un procédé de fabrication d'une diode Schottky sur un substrat de carbure de silicium.

Dans le domaine des composants semiconducteurs, le matériau principalement utilisé à l'heure actuelle est le silicium. Pour la tenue de tensions très élevées, le carbure de silicium est a priori préférable car le carbure de silicium peut supporter des tensions par unité d'épaisseur environ 10 fois plus élevées que le silicium.

Toutefois, dans l'état actuel des technologies, les filières couramment utilisées pour la réalisation de composants à base de silicium ne sont pas transposables pour la réalisation de composants à base de carbure de silicium (SiC). En particulier, il n'est actuellement pas possible en pratique de réaliser des implantations et diffusions de dopants de type P dans du carbure de silicium dopé de type N, en notant que le dopant de type P couramment utilisé pour le carbure de silicium est de l'aluminium et le dopant de type N est de l'azote. En effet, un recuit pour diffusion d'une implantation d'un dopant de type P nécessiterait des températures de l'ordre de 1700°C, ce qui pose des problèmes technologiques aigus.

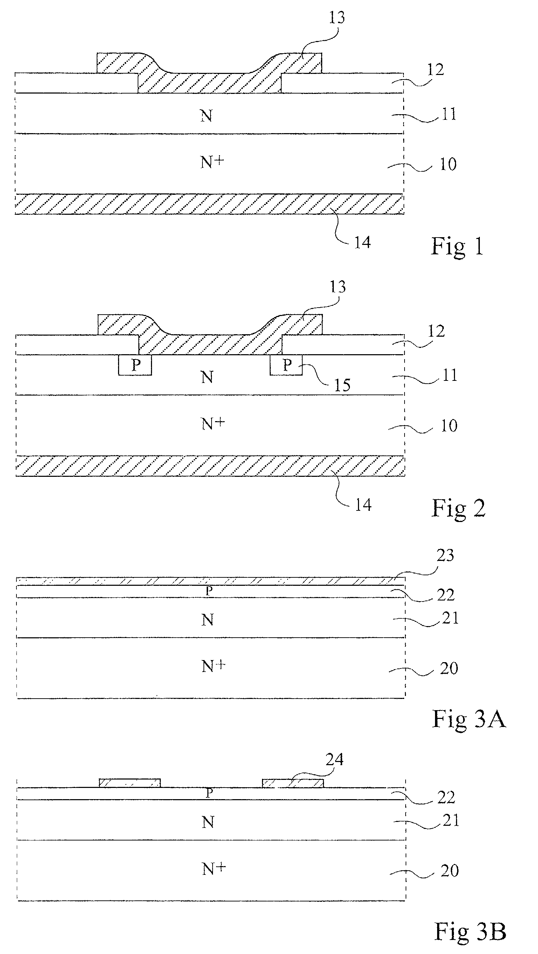

La structure élémentaire d'une diode Schottky est illustrée en figure 1. Cette diode est constituée à partir d'un substrat 10 de type N fortement dopé sur lequel est formée une couche épitaxiée 11 de type N convenablement dopée pour avoir la tenue en tension souhaitée. Sur cette couche épitaxiée N est déposé de l'oxyde de silicium 12 délimitant une fenêtre dans laquelle on veut établir le contact de Schottky au moyen d'une métallisation appropriée 13. La face arrière du composant est revêtue d'une métallisation 14.

Une telle structure présente une très mauvaise tenue en tension. En effet, les équipotentielles tendent à se recourber pour remonter vers la surface à la périphérie de la zone de contact et il en résulte, notamment dans les zones de courbure des équipotentielles de très fortes valeurs du champ qui limitent la tenue en tension en inverse possible. Pour éviter cet inconvénient, on utilise classiquement, pour des composants à base de silicium, la structure représentée en figure 2 dans laquelle un anneau périphérique 15 de type P est formé par implantation-diffusion à la périphérie de la zone active de la diode Schottky. Il en résulte que les équipotentielles doivent passer en volume sous les régions P et présentent donc une courbure moins marquée. Il convient que la concentration de dopants de l'anneau de type P soit plus élevée que celle de la couche épitaxiée pour repousser suffisamment les équipotentielles dans cette couche épitaxiée. La tenue en tension de la diode en est considérablement améliorée. A titre d'exemple avec une couche épitaxiée d'un niveau de dopage de 10¹⁶ at./cm³, on aura une tenue en tension de l'ordre de 10 V sans anneau de garde et de l'ordre de 50 V avec anneau de garde.

Toutefois, comme on l'a indiqué précédemment, la réalisation d'un tel anneau de garde de type P n'est pas réalisable de façon simple par implantation/diffusion dans une structure réalisée sur un substrat de carbure de silicium. Dans ce cas, la structure simple illustrée en figure 1 n'est pas non plus souhaitable pour les mêmes raisons que dans le cas d'un substrat de silicium.

La présente invention vise à prévoir un procédé de fabrication de diodes Schottky de tenue en tension relativement élevée qui puisse être mis en oeuvre simplement quand le semiconducteur est le carbure de silicium.

Pour atteindre cet objet, la présente invention prévoit un procédé de fabrication d'une diode Schottky verticale à anneau de garde sur une couche de carbure de silicium faiblement dopée de type N, comprenant les étapes suivantes : former une couche épitaxiée de type P sur la couche de type N ; implanter des dopants de type N dans des zones de la couche épitaxiée de type P pour neutraliser dans ces zones, sur toute l'épaisseur de la couche épitaxiée, les dopants de type P de façon à former des régions de type N, de concentration de dopants inférieure à celle de la couche épitaxiée, et délimiter un anneau de garde de type P ; former sur la périphérie externe du composant une couche isolante recouvrant partiellement l'anneau de garde ; et former un contact Schottky avec la région de type N interne à l'anneau de garde.

Selon un mode de réalisation de l'invention, on délimite lors de l'implantation de dopants N des régions supplémentaires de type P situées à l'intérieur de l'anneau de garde.

Selon un mode de réalisation de l'invention, on délimite lors de l'implantation de dopants N au moins un anneau supplémentaire situé à l'extérieur de l'anneau de garde.

Selon un mode de réalisation de l'invention, le procédé comporte en outre l'étape consistant à graver, préalablement à l'implantation de dopants N, des zones de la couche épitaxiée de type P sur une profondeur inférieure à l'épaisseur de ladite couche épitaxiée pour former des portions en saillie de type P.

Selon un mode de réalisation de l'invention, l'anneau de garde est délimité de façon à comprendre une portion en saillie située sur sa périphérie extérieure.

Selon un mode de réalisation de l'invention, la couche isolante recouvre la portion en saillie de l'anneau de garde.

Selon un mode de réalisation de l'invention, on implante des dopants de type N dans une portion en saillie de la couche épitaxiée de type P sur une profondeur inférieure à l'épaisseur de ladite portion pour former des régions de type N situées sur des régions de type P.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe simplifiée d'une diode Schottky élémentaire ;
la figure 2 est une vue en coupe simplifiée d'une diode Schottky classique sur un substrat de silicium ;
les figures 3A à 3E illustrent des étapes successives de formation d'une diode Schottky selon l'invention sur un substrat de carbure de silicium ;
les figures 4A et 4B illustrent des étapes de formation d'une variante de diode Schottky sur un substrat de carbure de silicium ; et
les figures 5A à 5C illustrent des étapes de formation d'une autre variante de diode Schottky sur un substrat de carbure de silicium.

Conformément à l'usage dans le domaine de la représentation des semiconducteurs, dans les différentes figures, les diverses couches ne sont pas tracées à l'échelle, ni dans leur dimension horizontale, ni dans leur dimension verticale.

Comme l'illustre la figure 3A, une diode Schottky est réalisée sur un substrat 20 en carbure de silicium de type N fortement dopé sur lequel on a fait croître une couche épitaxiée 21 de type N plus faiblement dopée. Sur la couche épitaxiée 21 de type N, on fait croître une couche épitaxiée 22 de type P plus fortement dopée que cette couche épitaxiée de type N. Une couche isolante 23, par exemple de l'oxyde de silicium, recouvre la couche 22 de type P. A titre d'exemple, la couche 22 de type P a une épaisseur de 0.5 µm et une concentration de dopants d'environ 3*10¹⁷ at./cm³ et la couche 21 de type N a une concentration de dopants d'environ 10¹⁵ à 2*10¹⁶ at./cm³.

Comme cela est représenté sur la figure 3B, on forme un masque 24 dans la couche isolante 23. Les motifs du masque correspondent aux empreintes des régions de type P que l'on souhaite délimiter dans la couche épitaxiée 22. Le masque 24 peut, par exemple, avoir une forme de couronne.

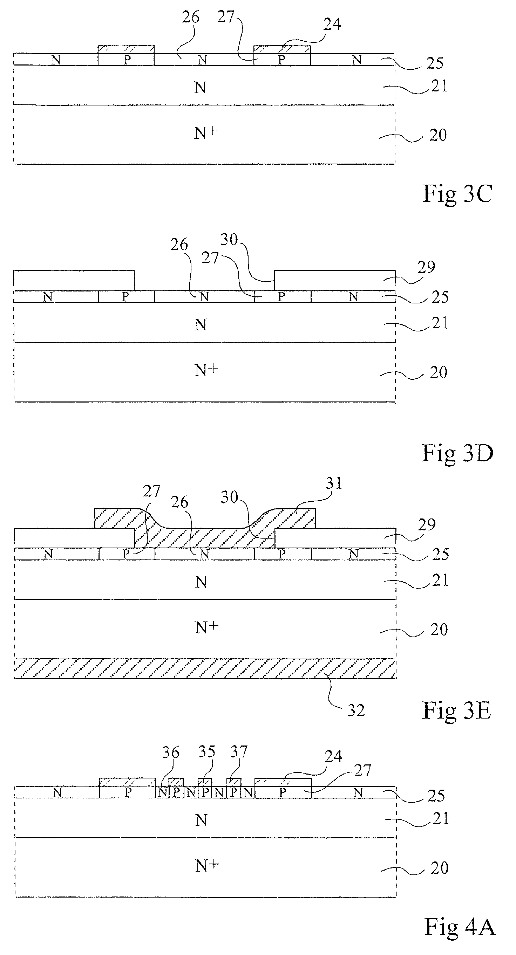

Comme l'illustre la figure 3C, on réalise une implantation dans la couche épitaxiée 22 de type P de dopants N, par exemple de l'azote, de façon à neutraliser les dopants P sur toute l'épaisseur de la couche épitaxiée 22 et former des régions faiblement dopées de type N qui s'étendent jusqu'à la couche épitaxiée 21 de type N. On forme ainsi des régions périphérique 25 et centrale 26 de type N faiblement dopées de part et d'autre d'un anneau de garde 27 de type P correspondant à la partie de la couche épitaxiée protégée par le masque 24. Selon une caractéristique de l'invention, l'implantation de dopants N est telle que les régions de type N 25, 26 obtenues sont plus faiblement dopées que l'anneau de garde 27 de type P. A titre d'exemple, les régions 25, 26 de type N faiblement dopées obtenues ont une concentration de dopants de l'ordre de 10¹⁶ at./cm³ du même ordre de grandeur que la concentration de dopants de la couche sous-jacente 21, tandis que l'anneau de garde 27 de type P a une concentration de dopants de l'ordre de 10¹⁷ at./cm³.

Comme cela est illustré par la figure 3D, après le retrait du masque 24, on recouvre la surface supérieure du substrat par une couche isolante 29, par exemple de l'oxyde de silicium, qui délimite une fenêtre 30 au niveau de laquelle on veut former la diode Schottky. La couche isolante 29 chevauche partiellement l'anneau de garde 27.

Comme cela est illustré sur la figure 3E, on dépose une couche de contact Schottky 31, par exemple un métal noble ou un siliciure de métal réfractaire, au niveau de la fenêtre 30 de la couche isolante 29. La couche 31 forme un contact Schottky avec la région centrale 26 de type N, et polarise l'anneau de garde 27 de type P. Une couche barrière (non représentée) peut être interposée entre la couche de contact Schottky 31 et les régions 26, 27 N et P sous-jacentes.

Une métallisation 32 recouvre la face inférieure du substrat 20. On obtient ainsi une diode Schottky verticale, formée sur un substrat en carbure de silicium et comportant une structure à anneau de garde adaptée pour une tenue en tension élevée.

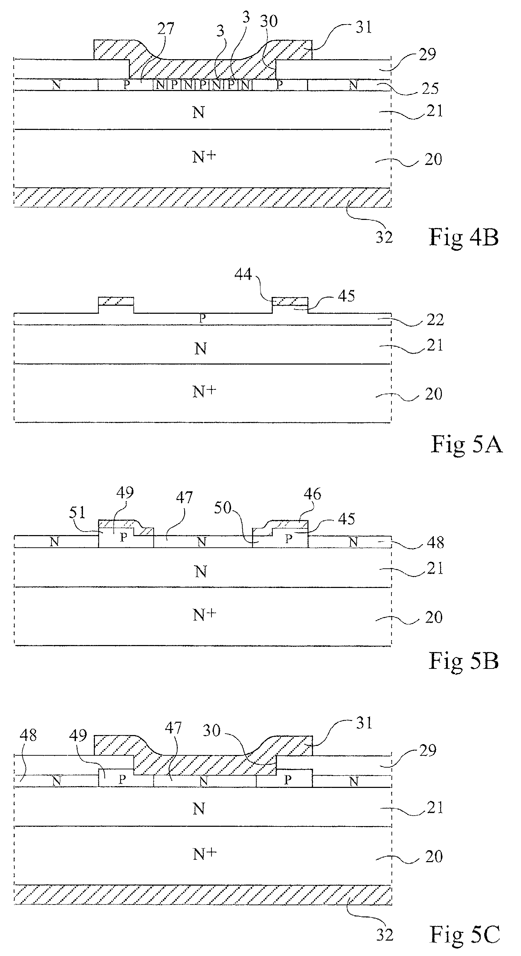

Les figures 4A et 4B illustrent des étapes d'un procédé de fabrication d'une variante de diode Schottky.

La figure 4A illustre une étape analogue à celle représentée sur la figure 3B. Par rapport au mode de réalisation précédent, le masque 24 comporte plusieurs motifs supplémentaires 35 en plus du motif en couronne de la figure 3B, de sorte que, lors de l'implantation de dopants N, on forme, à l'intérieur de l'anneau de garde 27 de type P, des régions de types N faiblement dopées 25, 36 alternant avec des régions 37 de type P.

La figure 4B illustre la diode ainsi obtenue après dépôt de la couche isolante 29, de la couche de contact Schottky 31, dans la fenêtre 30 délimitée par la couche isolante 29, et de la métallisation 32 sur la face inférieure du substrat 20.

On obtient ainsi une diode d'un type particulier, connue sous l'appellation diode Schottky/bipolaire. La couche de contact Schottky 29 est par endroits en contact avec les régions faiblement dopées de type N 36 avec lesquelles elle forme un contact Schottky, et par endroits en contact avec des régions de type P 37 avec lequel elle forme un contact ohmique. A titre d'exemple, les régions N 36 supplémentaires peuvent être disposées en anneaux concentriques équidistants de l'anneau de garde 27, ou être réparties suivant un damier ou des bandes parallèles à l'intérieur de l'anneau de garde 27. La distance entre les régions de type N et P 36, 37 est calculée d'une façon connue dans la technique pour optimiser la tenue en tension et le courant de fuite de la diode sous polarisation inverse.

En modifiant les motifs du masque 24, il est également possible de délimiter un ou plusieurs anneaux supplémentaires équidistants de l'anneau de garde 27 et disposés à l'extérieur de celui-ci. Ces anneaux extérieurs permettent de mieux contrôler la répartition des équipotentielles à la périphérie de la diode Schottky pour optimiser ses caractéristiques de tenue en tension. De tels anneaux supplémentaires extérieurs peuvent être également ajoutés à la structure de diode Schottky des figures 3A à 3E.

Les figures 5A à 5C illustrent des étapes successives d'un procédé de fabrication d'une variante de diode Schottky.

La figure 5A représente une étape du procédé précédant l'étape représentée sur la figure 3B. Un premier masque 44 est formé sur la couche épitaxiée de type P 22. On grave alors la couche épitaxiée 22 sur une profondeur inférieure à l'épaisseur de cette couche 22. On obtient ainsi, au niveau des zones non protégées par le masque 44, des régions de couche épitaxiée de type P d'épaisseur réduite, et au niveau de la zone protégée par le masque 44, une portion 45 en saillie. La gravure utilisée est par exemple une gravure anisotrope sèche.

La figure 5B représente la structure obtenue une fois que l'on a déposé un second masque 46 sur la face supérieure du substrat et réalisé une implantation de dopants N, par exemple de l'azote, de façon à former des régions faiblement dopées N. En particulier, on forme une région active centrale 47 et une région périphérique 48 de type N à l'extérieur d'un anneau de garde 49 de type P. L'anneau de garde 49 comporte une première partie intérieure 50 de faible épaisseur correspondant à une zone gravée préalablement de la couche épitaxiée 22 et une partie extérieure 51 d'épaisseur plus importante comprenant la portion en saillie 45.

La figure 5C représente la diode Schottky obtenue après le dépôt de la couche isolante 29, le dépôt de la couche de contact Schottky 31 dans la fenêtre 30 délimitée dans la couche isolante 29 et le dépôt d'une métallisation 32 sur la face inférieure du substrat 20. La couche isolante 29 recouvre la portion en saillie 45 de l'anneau de garde 49 et s'étend sensiblement jusqu'à la périphérie intérieure de la portion en saillie 45.

De façon plus générale, en modifiant les motifs du second masque, il est possible de graver la couche épitaxiée de type P pour obtenir une couche de type P d'épaisseur réduite comportant des portions de type P en saillie. Si l'on ne réalise pas alors d'implantation de dopants N dans les portions en saillie, on obtient finalement des régions de type P d'épaisseur élevée uniforme ou éventuellement en escalier. Si l'on implante des dopants N dans les portions en saillie sur toute l'épaisseur de la couche épitaxiée de type P, on peut éventuellement former des régions de type N d'épaisseur élevée uniforme ou en escalier. Enfin, si l'on implante des dopants N dans les portions en saillie sur une profondeur inférieure à l'épaisseur de la couche épitaxiée, on peut obtenir des régions de type N situées sur des régions de types P.

A titre d'exemple, on peut envisager une combinaison des différentes variantes précédemment décrites. Par exemple, on peut obtenir une diode Schottky/bipolaire, c'est-à-dire comprenant des régions de type P situées à l'intérieur de l'anneau de garde, et entourée en outre d'anneaux en saillie de type P ou N.

La présente invention présente de nombreux avantages.

Elle permet de réaliser une diode Schottky dans un substrat en carbure de silicium dopé N qui comporte un anneau de garde de type P pour une meilleure tenue en tension. Elle permet en outre de réaliser de façon simple une diode Schottky/bipolaire.

La possibilité de graver la couche épitaxiée de type P permet un contrôle précis de l'épaisseur de celle-ci. Il peut être intéressant de réduire l'épaisseur de la couche épitaxiée de type P pour faciliter l'inversion de la couche lors de l'implantation de dopants N.

Dans le cas où l'on réalise des anneaux périphériques entourant l'anneau de garde, on peut, par la gravure de la couche épitaxiée de type P modifier la quantité de porteurs de charges dans les anneaux périphériques.

Dans une structure en carbure de silicium, les implantations ont lieu sur de faibles épaisseurs, et il n'y a pas de diffusion jusqu'à des températures très élevées. Ceci permet de prévoir de façon précise les profils de dopants obtenus. Par des implantations successives, avec des énergies et des doses déterminées, il est possible d'obtenir des profils constants de dopage. Il est ainsi plus facile de compenser une couche épitaxiée réalisée dans une structure en carbure de silicium qu'en silicium et obtenir des régions faiblement dopées.

La présente invention permet de réaliser de façon simple parallèlement à la réalisation d'une diode Schottky d'autres structures pouvant éventuellement participer à la formation de transistors bipolaires ou MOS, ou de diodes.

Bien entendu, la présente invention est susceptible de diverses variantes et modifications qui apparaîtront à l'homme de l'art, en particulier en ce qui concerne les dimensions des diverses couches, tant verticalement qu'horizontalement.

## Revendications

1. Procédé de fabrication d'une diode Schottky verticale à anneau de garde (27) sur une couche (21) de carbure de silicium faiblement dopée de type N, **caractérisé en ce qu'**il comprend les étapes suivantes :
- former une couche épitaxiée (22) de type P sur la couche (21) de type N ;
- implanter des dopants de type N dans des zones de la couche épitaxiée (22) de type P pour neutraliser dans ces zones, sur toute l'épaisseur de la couche épitaxiée (22), les dopants de type P de façon à former des régions de type N (25, 26), de concentration de dopants inférieure à celle de la couche épitaxiée (22), et délimiter un anneau de garde de type P (27,49) ;
- former sur la périphérie externe du composant une couche isolante (29) recouvrant partiellement l'anneau de garde (27) ; et
- former un contact Schottky avec la région de type N (26) interne à l'anneau de garde (27).

2. Procédé selon la revendication 1, **caractérisé en ce qu'**on délimite lors de l'implantation de dopants N des régions supplémentaires (37) de type P situées à l'intérieur de l'anneau de garde (27, 49).

3. Procédé selon la revendication 1, **caractérisé en ce qu'**on délimite lors de l'implantation de dopants N au moins un anneau supplémentaire situé à l'extérieur de l'anneau de garde (27).

4. Procédé selon la revendication 1, **caractérisé en ce qu'**il comporte en outre l'étape consistant à graver, préalablement à l'implantation de dopants N, des zones de la couche épitaxiée (22) de type P sur une profondeur inférieure à l'épaisseur de ladite couche épitaxiée (22) pour former des portions en saillie (45) de type P.

5. Procédé selon la revendication 4, caractérisé en ce l'anneau de garde (49) est délimité de façon à comprendre une portion en saillie (45) située sur sa périphérie extérieure.

6. Procédé selon la revendication 5, **caractérisé en ce que** la couche isolante (29) recouvre la portion en saillie (45) de l'anneau de garde (49).

7. Procédé selon la revendication 4, **caractérisé en ce que** l'on implante des dopants de type N dans une portion en saillie (45) de la couche épitaxiée (22) de type P sur une profondeur inférieure à l'épaisseur de ladite portion (45) pour former des régions de type N situées sur des régions de type P.
